# EUROPEAN PATENT SPECIFICATION

(11) **EP 4 564 415 B1**
(45) Date of publication and mention of the grant of the patent: **17.06.2026**
(21) Application number: 24215524.0
(22) Date of filing: 26.11.2024
(51) Int. Cl.: H10P 50/28, H10P 50/00, H10W 70/05, H10P 70/00, H10W 70/09, H10W 70/698, H10W 99/00

(54) **MANUFACTURING METHOD FOR A PACKAGING SUBSTRATE**
HERSTELLUNGSVERFAHREN FÜR EIN VERPACKUNGSSUBSTRAT
PROCÉDÉ DE FABRICATION D'UN SUBSTRAT D'EMBALLAGE

(30) Priority: 30.11.2023 KR 20230171766
(43) Date of publication of application: 04.06.2025
(73) Proprietor: Absolics Inc., Covington, GA 30014 (US)
(72) Inventor: LEE, Jong Hyun, 18469 Hwaseong-si, Gyeonggi-do (KR); WOO, YONG HA, 18469 Hwaseong-si, Gyeonggi-do (KR); KIM, Jincheol, 18469 Hwaseong-si, Gyeonggi-do (KR)
(74) Representative: BCKIP Part mbB

(56) References cited:
- WO-A2-2023/014934
- KR-A- 20080 027 258
- US-A1- 2001 049 150
- US-A1- 2006 138 399
- US-A1- 2020 194 391
- US-A1- 2023 197 661
- US-A1- 2023 215 707
- US-A1- 2023 326 850

## Description

This application claims the priority of KR Application No. 10-2023-0171766 filed on November 30, 2023 in the Republic of Korea Patent and Trademark Office.

### TECHNICAL FIELD

The present invention relates to a method of manufacturing a packaging substrate.

### BACKGROUND

When building an electronic component, implementing the circuitry on a semiconductor wafer is called the Front-End (FE), and assembling the wafer into a product-ready state is called the Back-End (BE). The latter includes the packaging process.

There are four core technologies in the semiconductor industry that have enabled the rapid development of electronic products in recent years: semiconductor technology, semiconductor packaging technology, manufacturing process technology, and software technology. Semiconductor technology is advancing in various forms, including sub-micron to nano-scale line widths, more than 10 million cells, high-speed operation, and high heat dissipation, but the technology to package them perfectly is relatively inadequate. Therefore, the electrical performance of semiconductors is often determined by packaging technology and electrical connections rather than the performance of the semiconductor technology itself.

Ceramic or resin may be applied as material for packaging substrates. Ceramic substrates, such as silicon substrates, have high resistivity or high dielectric constant, making it difficult to mount high-performance, high-frequency semiconductor elements. In the case of resin substrates, it is possible to mount relatively high-performance, high-frequency semiconductor devices. However, there are limitations in reducing the pitch of the wiring.

Recently, glass plates can be applied as substrates for high-end packaging. By forming through-holes in the glass substrate and applying conductive materials to the through-holes, the wiring length between the element and the motherboard can be shortened and have good electrical characteristics.

Document US 2023 / 0 326 850 A1 discloses a semiconductor manufacturing method. The method includes forming a redistribution structure on a carrier, attaching an integrated passive device on a first side of the redistribution structure, attaching an interconnect structure to the first side of the redistribution structure, wherein the integrated passive device is interposed between the redistribution structure and the interconnect structure, depositing an underfill material between the interconnect structure and the redistribution structure, and attaching a semiconductor device on a second side of the redistribution structure that is opposite the first side of the redistribution structure.

Document US 2001 / 0 049 150 A1 discloses a method for etching an organic film. The organic film is etched by using plasma generated from an etching gas. The etching gas includes a first gas and a second gas. The first gas, as a principle constituent, comprises a compound including carbon, hydrogen and nitrogen. The second gas comprises a nitrogen component.

### SUMMARY

Against this background, the present invention provides a method of manufacturing a packaging substrate in accordance with claim 1. A method of manufacturing a packaging substrate according to the present invention, includes a preparation step of preparing a base substrate comprising a core layer and an insulating layer formed on the core layer, a patterning step of selectively plasma etching the insulating layer with an etching mask to form a patterned insulating layer, and a manufacturing step of manufacturing a packaging substrate from the base substrate on which the patterned insulating layer is formed.

The etching mask includes an organic compound.

An atmosphere temperature of the patterning step is 120°C or less.

In the patterning step, the etching mask may be disposed in contact with an upper surface of the insulating layer.

The insulating layer includes an etch target area.

The patterning step includes an etching process to etch a portion of the insulating layer in the etch target area, and a stabilization process to reduce the atmosphere temperature of the patterning step.

In the patterning step, performing the etching process and the stabilization process constitutes one cycle, and two or more cycles may be performed for each layer of the insulating layer.

The etching process may be performed for 200 seconds to 700 seconds per cycle.

The etching process may be performed in an atmosphere comprising a first etchant gas and a second etchant gas.

The first etchant gas may be a fluorine-based gas.

The second etchant gas may be oxygen gas.

The plasma power of the etching process may be at least 1.5 kW and not more than 3 kW.

A thickness of the etching mask may be 5 µm to 40 µm.

The method may further include a cleaning step of ultrasonically cleaning the base substrate after the patterning step and before the manufacturing step.

A vibration frequency of the cleaning step may be 30 kHz to 200 kHz.

The patterned insulating layer may include a through hole formed in a thickness direction of the insulating layer.

The through hole may have a diameter of 3 µm to 50 µm.

The packaging substrate may include the core layer, and the patterned insulating layer disposed on the core layer.

The packaging substrate may include an electrically conductive layer formed at least partially in contact with the patterned insulating layer.

A peel strength of the electrically conductive layer to the patterned insulating layer may be 200 gf/cm or more.

### BRIEF DESCRIPTION OF THE DRAWINGS

FIG. 1 is a conceptual diagram illustrating the preparation of the present invention.
FIGS. 2A and 2B are conceptual diagrams illustrating the patterning step of the present invention, respectively.
FIG. 3 is a conceptual diagram illustrating a packaging substrate manufactured according to a method of the present invention.

### DETAILED DESCRIPTION

Hereinafter, embodiments will be described in detail with reference to the accompanying drawings which may allow those skilled in the art to easily practice the present invention. However, the present invention may be implemented in various forms and is not limited to embodiments described herein. The same reference numerals are used for similar components throughout the specification.

Throughout the present specification, the term "combination thereof" included in expression of the Markush form refers to a mixture or combination of one or more selected from the group consisting of components disclosed in the expression of the Markush form, and refers to including the one or more selected from the group consisting of the components.

Throughout the present specification, terms such as "first," "second," "A" or "B" are used to distinguish the same terms. Further, a singular form includes a plural form unless otherwise clearly defined in the context.

In the present specification, "~" based may refer to including a compound corresponding to "~" or a derivative of the "~" in the compound.

In the present specification, "B is disposed on A" means that B is disposed directly on A or B is disposed on A while another layer is located therebetween, and is not understood as being limited to a case in which B is disposed in contact with the surface of A.

In the present specification, "B is connected on A" means that B is directly connected to A or B is connected to A through another component therebetween, and is not understood as being limited to a case in which B is directly connected to A unless otherwise specifically mentioned.

In the present specification, a singular form is interpreted as including a singular form or plural form unless otherwise specifically described.

In the present specification, shapes, relative sizes, angles, and the like of components in the drawings are illustrative and may be exaggerated for the purpose of description, and the scope is not understood as being limited to the drawings.

In the present specification, a case in which "B is adjacent to A" means that A and B are located in contact with each other or A and B are located close to each other although not in contact with each other. The expression that "A and B are adjacent to each other" is not understood as being limited to a case in which A and B are located in contact with each other unless otherwise specifically mentioned.

In the present specification, unless otherwise described, a fine line refers to a line having a width of 5 µm or less, and for example, refers to a line having a width of 1 to 4 µm or less.

Below, the present invention is described below.

A method of manufacturing a packaging substrate of the present invention includes a preparing step of preparing a base substrate comprising a core layer and an insulating layer formed on the core layer, a patterning step of selectively plasma etching the insulating layer with an etching mask to prepare a patterned insulating layer, and a manufacturing step of manufacturing a packaging substrate from the base substrate on which the patterned insulating layer is formed.

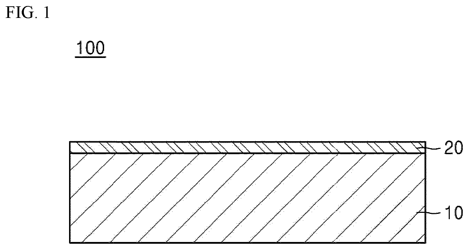

FIG. 1 is a conceptual diagram illustrating a preparing step of the present invention. Referring to FIG. 1, a method of manufacturing a packaging substrate of the present invention will be described.

### Preparation Step

In a preparing step, a base substrate 100 including a core layer 10 and an insulating layer 20 formed on the core layer 10 is prepared.

The core layer 10 may have the shape of a substrate. The core layer 10 is any substrate that may be applied as an electronic component.

Material of the core layer 10 may be an organic material, glass, alumina, aluminum nitride, silicon carbide, or silicon nitride.

The core layer 10 may be a glass core. The core layer 10 may be an alkali borosilicate plate glass, an alkali-free borosilicate plate glass, an alkali-free alkali earth metal borosilicate plate glass, and the like. The core layer 10 may be a glass substrate for an electronic device, such as, but not limited to, a glass substrate manufactured by SCHOTT, AGC, Corning, or the like.

The core layer 10 may include a top surface and a side surface connected to the top surface and formed in the thickness direction of the core layer 10. The surface of the core layer 10 may include a bottom surface facing the top surface.

"The side surface formed in the thickness direction of the core layer 10" is interpreted to include not only the side surface formed a perpendicular to the top surface of the core layer 10, but also at least a portion of the side surface formed an angle (inclination angle) other than 90 degrees to the top surface.

The side surface may be flat or curved.

The core layer 10 may include a cavity (not shown), which is a space formed by the inward recess of a portion of the core layer 10.

The cavity may be formed by a recess of a portion of the top surface and/or bottom surface of the core layer 10 in the thickness direction of the core layer 10 and may be penetrated in the thickness direction of the core layer 10.

A cavity may provide a space in which a device may be mounted. The device mounted in the cavity may be electrically connected to other components within the packaging substrate. The devices may be a semiconductor device such as CPU, GPU, memory chip, and the like, as well as capacitor device, transistor device, impedance device, other module, and the like. In other words, any device that can be mounted on a semiconductor product may be applied as a device.

The core layer 10 may include through-via part (not shown) that penetrates the core layer 10 in a thickness direction.

The through-via part includes a via space, which is an area in which the electrically conductive layer is disposed of, and a via inner diameter surface surrounding the via space. The via inner diameter surface refers to an inner surface of the core layer 10 formed in the through-via part.

The via space may have substantially uniform inner diameter in the direction of the core layer 10. The via space may have an inner diameter that varies in the thickness direction of the core layer 10.

In a preparing step, when a glass core is applied as the core layer 10, the glass core may be etched to provide the through via part. Specifically, defects may be formed at predetermined locations on the surface of the glass core. As a method for forming defects, mechanical etching, laser irradiation, and the like may be applied.

The through via part may be formed by physical or chemical etching the damaged area. If chemical etching is applied, wet etching with an etchant solution may be performed. The etchant solution may be one that is conventionally applicable to etching glass substrates. For example, etchant solution may be sulfuric acid solution, nitric acid solution, hydrofluoric acid solution, or the like.

During the etching process, the rest of the glass core surface may be masked except for the area where defects are formed, or the etching may proceed without masking.

A defect may be formed at a point on the upper surface of the glass core, a defect may be formed at another point on the lower surface of the glass core facing the point, and etching may be performed to provide the through via part.

The base substrate 100 may include an electrically conductive layer formed in the via space. The electrically conductive layer may be formed by filling at least a portion of the via space and may be formed as a thin film on the via inner diameter surface. When the electrically conductive layer is formed in the form of a thin film on the via inner diameter surface, the remaining space in the via space other than the space occupied by the electrically conductive layer may be filled with an insulating layer.

The electrically conductive layer disposed in the via space may transmit electrical signals in the thickness direction of the core layer 10, and may electrically connect the device, the motherboard, the rewiring layer, and the like to each other.

Descriptions of the material of the insulation layer and the electrically conductive layer are redundant with the below description and will be omitted.

The base substrate 100 includes an insulating layer 20 formed on the core layer 10. The insulating layer 20 may be formed abutting the top surface of the core layer 10. The base substrate 100 may further include an electrically conductive layer (not shown) disposed between the core layer 10 and the insulating layer 20. The insulating layer 20 may be disposed on top of the electrically conductive layer and may surround the electrically conductive layer.

The insulating layer 20 is any one that can be applied as an insulating layer to a semiconductor device or packaging substrate. For example, the insulating layer 20 may include an epoxy-based resin containing a filler or the like. The insulating layer 20 may be formed by, for example, but not limited to, a build-up layer material such as Ajinomoto Build-up Film (ABF), an undercoat material, or the like.

An electrically conductive layer corresponds to wiring that carries electrical signals. The electrically conductive layer may include an electrically conductive material. For example, the electrically conductive layer may include at least one of copper, nickel, aluminum, gold, or silver. As a material for the electrically conductive layer, copper may be applied.

In a preparing step, the base substrate 100 may be prepared with the insulating layer 20 pre-formed on the core layer 10. In a preparing step, the base substrate 100 may be prepared by forming an insulating layer 20 on the core layer 10.

The insulating layer 20 may be formed by laminating a film-shaped insulating resin on the core layer 10. For example, the film-shaped insulating layer 20 may be pressure-reduced laminated on the core layer 10 to form the base substrate 100. In this case, the surface of the electrically conductive layer disposed below the insulating layer 20 may be surrounded without voids.

### Patterning Step

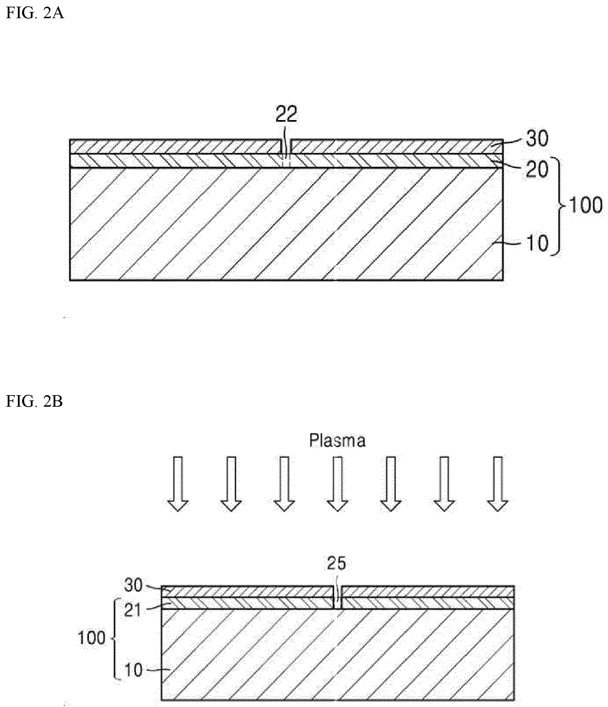

FIGS. 2A and 2B are conceptual diagrams illustrating the patterning step of the present invention, respectively. Referring to FIGS. 2A and 2B above, a method of manufacturing a packaging substrate of the present invention will be described.

The base substrate 100 includes a core layer 10 and an insulating layer 20 formed on the core layer 10. The specific configuration of the base substrate 100 is as described in FIG. 1 above. Differences will be described in the following.

**In** the patterning step, the insulating layer 20 is selectively plasma etched with an etching mask 30 to form a patterned insulating layer 21.

The etching mask 30 may help form a predesigned pattern in the insulating layer 20 during the patterning step. The etching mask 30 may include the same pattern as the pattern desired to be formed on the insulating layer 20 in the patterning step. The etching mask 30 may include the same hole pattern desired to be formed in the insulating layer 20 in the patterning step.

The etching mask 30 includes an organic compound. The etching mask 30 may be a patterned resist film. Unlike a metal etching mask, the etching mask 30 of the present invention may be easily removed by peeling after patterning the insulating layer 20 without etching the etching mask 30. In this way, the etching mask 30 may be removed without causing undue damage to the insulating layer 20 and leaving substantially no debris on the insulating layer 20 during the removal process. Furthermore, in this case, the deterioration of the bonding force between the electrically conductive layer formed on the insulating layer 20 and the insulating layer 20 may be suppressed.

The resist film may be any one conventionally used in the field of packaging substrates. The resist film may include an amine-based resist. The resist film may include a positive resist. The resist film may include a negative resist.

The etching mask 30 may be disposed abutting the top surface of the insulating layer 20. Specifically, a resist composition may be applied and cured on the insulating layer 20 to form a resist film, and the etching mask 30 may be formed by patterning the resist film.

When forming the resist film, the resist composition may be applied so that the resist composition covers the whole top surface of the insulating layer 20. The thickness of the applied resist composition and the thickness of the cured resist film may be adjusted in consideration of the thickness of the etching mask 30 being manufactured.

When patterning the resist film, the resist film may be selectively irradiated with light according to the pattern shape to be formed on the insulating layer 20, and then the light-irradiated resist film may be developed to form the etching mask 30. For example, irradiation of the resist film may be performed by an electron beam.

The thickness of the etching mask 30 may be from 5 µm to 40 µm. The thickness may be 10 µm or more. The thickness may be 15 µm or more. The thickness may be 35 µm or less. The thickness may be 30 µm or less. In such a case, the etching mask 30 may remain after the patterning step, which may assist in selective etching of the insulating layer 20 and may contribute to achieving precise patterning of the insulating layer 20.

In the patterning step, the insulating layer 20 is patterned by plasma etching. The atmosphere temperature of the patterning step is 120°C or less.

After the base substrate 100 with the etching mask 30 formed is placed in the etching chamber, etchant gas may be introduced into the chamber, and plasma power may be applied to plasma etch the insulating layer.

In the patterning step, the insulating layer 20 is selectively plasma etched through the etching mask 30 to form the patterned insulating layer 21. According to the present invention, the etch target area 22 included in the insulating layer 20 is plasma etched to form the patterned insulating layer 21. The etch target area 22 is a region included in the insulating layer 20 that is removed by plasma etching in the patterning step. The etch target area 22 corresponds to an area exposed to the outside in the insulating layer 20 when the etching mask 30 is disposed on the top surface of the insulating layer 20.

In the process of performing plasma etching successively, the atmosphere temperature of the patterning step, specifically the temperature inside the etching chamber, may rise continuously. In this case, the etching mask 30 may deteriorate. The deteriorated etching mask 30 may become sticky and not be easily removed from the surface of the insulating layer 20. In addition, shape of the etching mask 30 may also be deformed, which may cause problems in implementing sophisticated patterns on the insulating layer 20. As a result, a number of debris may remain on the insulating layer after removal of the etching mask 30, and the electrical reliability of the manufactured packaging substrate may be debased.

In the present invention, the atmosphere temperature of the patterning step, i.e., the temperature inside the chamber may be controlled to be within the preset range to help inhibit degradation of the etching mask 30 and to enable more precise and reliable realization of the high-density rewiring layer on the core layer 10.

The atmosphere temperature of the patterning step is 120°C or less. The atmosphere temperature may be 115°C or less. The atmosphere temperature may be 110°C or less. The atmosphere temperature may be 100°C or less. The atmosphere temperature may be 30°C or more. The atmosphere temperature may be 50°C or higher. The atmosphere temperature may be above 70°C. The atmosphere temperature may be 80°C or higher. In such cases, a stable plasma state may be maintained during the patterning step while suppressing deterioration of the etching mask 30.

The patterning step includes an etching process to etch a portion of the insulating layer 20 in the etch target area 22 and a stabilization process to reduce the atmosphere temperature of the patterning step.

In one etching process, rather than continuously etching the insulating layer 20 in the etch target area 22 at once, the insulating layer 20 disposed in the etch target area 22 may be etched in the thickness direction of the insulating layer 20 over a plurality of times. By doing so, the exposure of the etching mask 30 to high temperatures may be suppressed from being exposed to a high temperature for extended periods.

The etching process may be performed from 200 to 700 seconds per one session. The etching process may be performed for 250 seconds or more per one session. The etching process may be performed for 300 seconds or more per one session. The etching process may be performed for 350 seconds or more per one session. The etching process may be performed for 650 seconds or less per one session. The etching process may be performed for 600 seconds or less per one session. The etching process may be performed for 550 seconds or less per one session. In such a case, a pattern having a fine pitch may be formed more precisely in the insulating layer 20, and the debris of the etching mask 30 may be inhibited from being adsorbed on the insulating layer 20 during the process of removing the etching mask 30.

The etching process may be carried out in an atmosphere comprising a first etchant gas and a second etchant gas. The first etchant gas may be a fluorine-based gas. More specifically, the first etchant gas may be any one selected from the group consisting of carbon fluoride, nitrogen fluoride, sulfur fluoride, and combinations thereof.

The carbon fluoride may be, for example, any one selected from the group consisting of CF₄, CHF₃, CH₂F₂, CH₃F, and combinations thereof.

Nitrogen fluoride may be NF₃. Sulfur fluoride may be SF₆.

The first etchant gas may be nitrogen fluoride.

The second etchant gas may be oxygen gas.

In the present invention, the first etchant gas and the second etchant gas may be applied together as the atmosphere gas during the etching process to increase the etching rate for the insulating layer 20.

In the etching process, the plasma power may be 1.5 kW to 3 kW. The plasma power may be 1.7 kW or more. The plasma power may be 2 kW or more. The plasma power may be 2.7 kW or less. The plasma power may be 2.5 kW or less. In such cases, a certain level of etching rate for the insulating layer 20 may be retained, and excessive damage to the insulating layer 20 by plasma etching may be prevented.

In the present invention, overheating the etching mask 30 may be inhibited through a stabilization process after completing one session of the etching process. Specifically, the plasma power supply may stop during the stabilization process so that the atmosphere temperature during the stabilization process is lower than the atmosphere temperature during the etching process.

The stabilization process may proceed until the atmosphere temperature, i.e. the temperature inside the chamber, reaches the desired temperature. The target temperature may be at least 5°C lower than the maximum value of the atmosphere temperature during the etching process. More specifically, the target temperature may be at least 10°C lower than the maximum value of the atmosphere temperature during the etching process. Further, the desired temperature may be at least 15°C lower than the maximum value of the atmosphere temperature during the etching process. This may help to prevent deformation of the etching mask 30 and facilitate easy peeling of the etching mask 30 after the patterning step.

During the patterning step, the temperature of the etching mask 30 may be reduced by allowing a cooling fluid to pass outside of the etching chamber, particularly around the portion of the chamber where the base substrate 100 is disposed. The cooling fluid may pass around the area where the base substrate 100 is disposed during the etching process and stabilization process.

The cooling fluid may be a liquid or a gas. If the cooling fluid is liquid, pipes through which the cooling fluid flows may be disposed around the outer periphery of the etching chamber, and the cooling fluid may be circulated through the pipes to cool the interior of the chamber. The cooling fluid may be water.

If the cooling fluid is a gas, the gas may be supplied through a pipe similar to the liquid cooling fluid, or the gas may be sprayed outside the chamber to cool the inside of the chamber. The cooling fluid may be air, or a less reactive gas such as helium or nitrogen.

In the patterning step, performing the etching process and the stabilization process is considered to be one cycle, and two or more cycles are performed for each layer of the insulating layer 20. More specifically, in the patterning step, more than 3 cycles may be performed per one layer of the insulating layer. In the patterning step, 10 or fewer cycles may be performed per one layer of the insulating layer. In such cases, the time spent in the patterning step may be controlled and fine patterning of the insulating layer 20 may be achieved.

The patterned insulating layer 21 provided by the etching process may include through holes 25 formed in the thickness direction of the insulating layer 20. The through holes 25 may connect the top side and the bottom side of the insulating layer 20. An electrically conductive layer (not shown) may be disposed within the through hole 25. The electrically conductive layer disposed in the through hole 25 may electrical connect the electrically conductive layer (not shown) disposed on the insulating layer 20 and the electrically conductive layer (not shown) disposed under the insulating layer 20.

The through hole 25 may have a diameter of 3 µm to 50 µm. The diameter may be 5 µm or more. The diameter may be 7 µm or more. The diameter may be 40 µm or less. The diameter may be 30 µm or less. The diameter may be 20 µm or less. The diameter may be 15 µm or less. In such cases, an electrically conductive layer having a higher density may be stably formed.

In the patterning step, after patterning the insulating layer 20, the etching mask 30 may be removed. The etching mask 30 has a controlled adhesion to the top surface of the insulating layer 20, allowing for easy physical delamination and removal of the etching mask 30. In this way, a separate complex process such as an etching process is not required to remove the etching mask 30, which may improve process convenience and reduce damage to the insulating layer 20. Furthermore, since the upper surface of the insulating layer 20 after the etching mask 30 is removed by the method described above is substantially free of remnants of the etching mask 30 and has a smooth surface, the electrically conductive layer formed on the upper surface of the insulating layer 20 may have an excellent bonding force to the insulating layer 20.

The etching mask 30 may be removed at an atmosphere temperature of 30°C to 60°C. More specifically, the atmosphere temperature may be 35°C or higher. Further, the atmosphere temperature may be 40°C or higher. Conversely, the atmosphere temperature may be 55°C or less. The atmosphere temperature may be 50°C or less. In such cases, the remnants of the etching mask 30 remaining on the insulating layer 20 may be effectively suppressed.

### Cleaning Step

The method of manufacturing the packaging substrate of the present invention may further include a cleaning step of ultrasonically cleaning the base substrate 100 after the patterning step and before the manufacturing step.

In the process of plasma etching the insulating layer 20, particles originated from the insulating layer 20 may be generated. The particles may be retained and adsorbed on a surface of the through hole 25 having a fine pitch in the insulating layer 20 and on the top surface of the insulating layer 20, and may cause defects in the process of forming an electrically conductive layer in the through holes 25 and on the top surface of the insulating layer 20.

The cleaning step of the present invention may involve immersing the base substrate 100 with the particle residue in a water bath and subjecting the water bath to ultrasonic vibrations to create a cavitation phenomenon. This allows the base substrate 100 to be easily cleaned of the particles without unduly damaging the base substrate 100 during the cleaning step.

In the cleaning step of the present invention, the vibration frequency may be from 30 kHz to 200 kHz. More specifically, the vibration frequency may be 50 kHz or more. Further, the vibration frequency may be greater than or equal to 70 kHz. The vibration frequency may be greater than or equal to 100 kHz. Conversely, the vibration frequency may be 150 kHz or less. In such cases, even if the insulating layer 20 has a fine and complex pattern structure, the base substrate 100 may be effectively cleaned without causing significant damage.

### Manufacturing Step

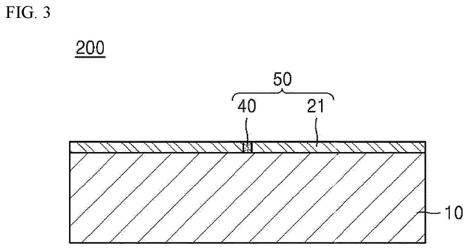

FIG. 3 is a conceptual diagram illustrating a packaging substrate manufactured in accordance with the method of the present invention. Referring to FIG. 3, a method of manufacturing a packaging substrate of the present invention will be described.

In a manufacturing step, a packaging substrate 200 may be manufactured from the base substrate 100 on which the patterned insulating layer 21 is formed.

In the manufacturing step, the first redistribution layer 50 may be manufactured by plasma etching to form an electrically conductive layer 40 in the area where the insulating layer 20 has been etched away, in particular in the through holes.

The electrically conductive layer 40 may be formed in a dry method or a wet method.

The dry method is a method of forming the electrically conductive layer 40 by sputtering the area where the electrically conductive layer 40 is to be disposed to form a seed layer, and plating the area where the seed layer is formed to form the electrically conductive layer 40. When forming the seed layer, a metal such as titanium, chromium, nickel, and the like may be sputtered, and copper may be sputtered in combination with the above metals. Sputtering may lead to an anchor effect in which the deposited metal particles interact with the surface on which the electrically conductive layer 40 is disposed, thereby improving the adhesion of the electrically conductive layer 40.

In the wet method, a primer is applied to the area where the electrically conductive layer 40 is to be formed, followed by metal plating. The primer may include a compound having a functional group such as amine. Depending on the degree of adhesion desired, the primer may include an amine or other functional group together with a silane coupling agent. When a silane coupling agent is applied, the primer-treated surface may be pretreated with the silane coupling agent and then a compound having an amine group may be applied to the pretreated area to form a primer layer.

After forming the seed layer or primer layer, the metal may be plated to form the electrically conductive layer 40. For example, but not limited to, copper plating may be applied to form the electrically conductive layer 40. Prior to plating the metal, the portion of the seed layer or primer layer that does not need to form the electrically conductive layer 40 may be deactivated, or the portion that does need to form the electrically conductive layer 40 may be activated and then plated. The activation or deactivation treatment method may include a light irradiation treatment such as irradiation with a laser of a specific wavelength, a chemical treatment, or the like. However, after metal plating without applying an activation or deactivation treatment, the electrically conductive layer 40 may be etched and patterned according to a predesigned shape.

If the patterned insulating layer 21 includes a hole pattern, an electrically conductive layer 40 may be formed in the through hole in the insulating layer 20. The electrically conductive layer 40 may electrically connect an electrically conductive layer (not shown) located on the upper side and an electrically conductive layer (not shown) located on the lower side.

If the structure of the predesigned first redistribution layer 50 is a plural-layer structure, other patterned insulating layer (not shown) and electrically conductive layer (not shown) may be formed on the patterned insulating layer 21 and electrically conductive layer 40. Other patterned insulating layer and electrically conductive layers disposed on the patterned insulating layer 21 and the electrically conductive layer 40 may be formed according to the methods described above.

If the first redistribution layer 50 has a plural-layer structure, an electrically conductive layer with a smaller width may be disposed upwardly in the first redistribution layer 50. Similarly, an electrically conductive layer with thinner thickness may be disposed upwardly in the first redistribution layer 50. Furthermore, an electrically conductive layer with a smaller pitch may be formed upwardly in the first redistribution layer 50. In this way, the first redistribution layer 50 may form a stable electrical connection with the semiconductor device having a fine pattern.

The manufacturing step may further include forming a second redistribution layer that is disposed below the core layer 10 if necessary. The second redistribution layer may have a single layer structure or a plural layer structure. The redistribution layer formed below the core layer 10 may be formed by the same method as described above.

If the second redistribution layer has a plural-layer structure, an electrically conductive layer with a wider width may be arranged downwardly in the second redistribution layer. Similarly, an electrically conductive layer with a thicker thickness may be disposed downwardly in the second redistribution layer. Furthermore, an electrically conductive layer with a larger pitch may be formed downwardly in the second redistribution layer. In this way, the second redistribution layer may form a stable electrical connection with the main board on which the wide or thick electrically conductive layer is formed.

In the manufacturing step, the packaging substrate 200 may be prepared by finalizing the formation of a redistribution layer having a predesigned structure on top and/or bottom of the core layer 10.

If desired, additional terminals or the like may be formed on the top and/or bottom sides of the packaging substrate 200 in the manufacturing step, and bumps may be further formed on the bottom of the packaging substrate 200. The bumps may be disposed of in a predetermined shape below the redistribution layer disposed below the core layer 10. For example, the bumps may be disposed of on a portion of the lower side of the packaging substrate 200 to face a motherboard or the like.

### Manufactured Packaging Substrate

The packaging substrate 200 manufactured according to the method of manufacturing the packaging substrate of the present invention may include the core layer 10 and the patterned insulating layer 21 disposed on the core layer 10.

The packaging substrate 200 may further include an electrically conductive layer (not shown) formed at least partially abutting the top surface of the patterned insulating layer 21.

A description of the material and structure of the core layer 10 and the patterned insulating layer 21 is omitted as it is redundant to the foregoing.

The patterned insulating layer 21 may include a through hole (not shown) formed in the direction of the thickness of the insulating layer 20. The electrically conductive layer 40 may be formed within the through hole.

The electrically conductive layer formed at least partially in contact with the top surface of the patterned insulating layer 21 may be formed in a dry method or wet method as described above on the patterned insulating layer 21 and the electrically conductive layer.

In the packaging substrate 200 manufactured according to the method of manufacturing the packaging substrate of the present invention, the electrically conductive layer formed in contact with the upper surface of the patterned insulating layer 21 may have a good bonding force to the insulating layer 20. This is thought to be because, after patterning the insulating layer, the etching mask may be easily removed without substantially causing damage or deformation of the patterned insulating layer 21, and the etching mask may leave substantially no residue on the surface of the patterned insulating layer 21. In this way, it is possible to help the top surface of the patterned insulating layer 21 maintain a smooth surface even after removal of the etching mask.

The peeling strength between the patterned insulating layer 21 and the electrically conductive layer is measured in the following way. After cutting the electrically conductive layer formed on the patterned insulating layer 21 to a width of 1 cm, the peeling strength is measured while peeling off 3cm of the electrically conductive layer from the insulating layer 20 by applying a peeling speed of 847 µm/s with a Universal Testing Machine (UTM). From the measured peeling strength distribution, the average value of the peeling strength in the saturation section is calculated and the value is designated to the peeling strength between the patterned insulating layer 21 and the electrically conductive layer.

The peel strength of the electrically conductive layer to the top surface of the patterned insulating layer 21 may be 200 gf/cm or more. More specifically, the peel strength may be 250 gf/cm or more. Further, the peel strength may be 300 gf/cm or more. Ideally, the peel strength may be 320 gf/cm or more. Conversely, the peel strength may be 500 gf/cm or less. In such cases, the electrically conductive layer may be reliably fixed on the top surface of the patterned insulating layer 21, and the manufactured packaging substrate 200 may have good electrical reliability.

The through hole 25 included in the patterned insulating layer 21 may have a diameter of 3 µm to 50 µm. More specifically, the diameter may be 5 µm or more. Further, the diameter may be 7 µm or more. Conversely, the diameter may be 40 µm or less. More specifically, the diameter may be 30 µm or less. Further, the diameter may be 20 µm or less. Ideally, the diameter may be 15 µm or less. In such cases, a pattern of through hole 25 having a higher pattern density in the insulating layer may be reliably realized.

Hereinafter, the present invention will be described in more detail with specific examples. The following embodiments are provided by way of example only to illustrate the present invention and are not intended to limit the scope of the present invention.

### Manufacturing Example: Manufacturing a Packaging Substrate

Example 1: Ajinomoto Build-up Film (ABF) was laminated with reduced pressured on the top surface of Corning's glass plate SG7.8 to form an insulating layer to prepare the base substrate.

A resist composition of RESONAC's DRY FILM PHOTEC (RY series) was applied and cured on the insulating layer to form a resist film with a thickness of 5 to 40 µm. The resist film was exposed to an electron beam, and the exposed resist film was developed to form an etching mask with a hole pattern having a diameter of 7 to 10 µm.

The base substrate with the etching mask formed was placed in the etching chamber, and the insulating layer was plasma etched and patterned. During plasma etching, the plasma power was applied at 1.5 kW, and NF₃ 150 sccm as the first etchant gas and O₂ 150 sccm as the second etchant gas were supplied into the chamber.

Plasma etching was performed three times, each time for 500 seconds. After each plasma etch, the etching was stopped for 60 seconds. During the patterning of the insulating layer, the temperature inside the chamber was controlled to be less than 120°C by blowing helium gas onto the lower side of the etching chamber.

After patterning the insulating layer, the etching mask was peeled off under an atmosphere temperature of 30°C to 55°C. The base substrate with the etching mask peeled off was immersed in a bath of water and ultrasonically cleaned for 300 seconds at a vibration frequency of 100 kHz.

After cleaning, sputtering was performed on the etched space in the insulating layer to form a titanium layer and a copper layer disposed on the titanium layer, and copper electrolytic plating was performed on the copper layer to form an electrically conductive layer and complete the packaging substrate.

Example 2: The packaging substrate was prepared under the same conditions as in Example 1, except that a vibration frequency of 50 kHz was applied during ultrasonic cleaning.

Example 3: The packaging substrate was prepared under the same conditions as in Example 1, except that a vibration frequency of 130 kHz was applied during ultrasonic cleaning.

Comparative Example 1: The packaging substrate was manufactured under the same conditions as in Example 1, except that the cooling process via helium gas injection was not performed during the patterning of the insulating layer.

Comparative Example 2: After patterning the insulating layer, the packaging substrate was fabricated under the same conditions as in Example 1, except that no ultrasonic cleaning was performed.

### Evaluation Example: Evaluation of Etching mask Delamination

The top surface of the patterned insulating layer for each Example and Comparative Example was observed with the naked eye to determine if any debris from the etching mask was found. If no debris was detected, it was evaluated as Pass, and if debris was detected, it was evaluated as Fail.

The measurements for each Example and Comparative Example are listed in Table 1 below.

### Evaluation Example: Cleaning Evaluation

In the packaging substrates of the Examples and Comparative Examples, the through holes in the patterned insulating layer were observed under an optical microscope to determine whether particles were retained. If no particles were detected, the test result was evaluated as Pass, and if particles were detected, the test result was evaluated as Fail.

The measurements for each Example and Comparative Example are listed in Table 1 below.

### Evaluation Example: Evaluating the Peel Strength of an Electrically conductive Layer

In Examples 1 to 3 and Comparative Example 2, an electrically conductive layer was further formed on the patterned insulating layer. A titanium target was applied and sputtered to form a titanium layer with a thickness of 50 nm. After sputtering with a titanium target, a copper target was applied and sputtered to form a copper layer with a thickness of 100 nm on the titanium layer. Copper electrolytic plating was performed on the above copper layer to form an additional copper layer with a thickness of 20 µm.

The peeling strength of the electrically conductive layer on the patterned insulating layer was measured in the following manner. The electrically conductive layer formed on the patterned insulating layer was cut into a 1cm wide strip, and the peeling strength was measured while peeling off 3 cm of the electrically conductive layer from the insulating layer using a Universal Testing Machine (UTM) with a peeling speed of 847 µm/s. From the measured peel strength distribution, the average value of the peel strength in the saturation section was calculated and the value was designated to the peel strength between the patterned insulating layer and the electrically conductive layer.

The measurements for each Example and Comparative Example are listed in Table 1 below.

**[Table 1]**

| | delamination evaluation | cleaning evaluation | peel strength evaluation (gf/cm) |
|---|---|---|---|
| Example 1 | Pass | Pass | 340 |
| Example 2 | Pass | Pass | 280 |
| Example 3 | Pass | Pass | 320 |
| Comparative Example 1 | Fail | Pass | - |
| Comparative Example 2 | Pass | Fail | 60 |

In the delamination evaluation in Table 1 above, Examples 1 to 3 were evaluated as Pass, while Comparative Example 1 was evaluated as Fail. This means that the etching mask may be easily removed when the atmosphere temperature is controlled within the preset range in the present invention during the patterning step.

In the cleaning evaluation, Examples 1 to 3 were evaluated as Pass, while Comparative Example 2 was evaluated as Fail. This means that the ultrasonic cleaning facilitates the removal of particles adsorbed in the through holes in the patterned insulating layer.

In the peel strength evaluation, Examples 1 to 3 were evaluated as 250 gf/cm or more, while Comparative Example 2 was evaluated as 00 gf/cm or less. This is believed to be due to the remnants of the insulating layer caused by the etching remaining on the top surface of the patterned insulating layer and interfering with the bonding between the electrically conductive layer and the patterned insulating layer.

## Claims

1. A method of manufacturing a packaging substrate (200), the method comprising:
a preparing step of preparing a base substrate (100) comprising a core layer (10) and an insulating layer (20) formed on the core layer (10), wherein the insulating layer (20) comprises an etch target area (22);
a patterning step selectively plasma etching the insulating layer (20) with an etching mask (30) to form a patterned insulating layer (21), wherein the etching mask (30) comprises an organic compound, wherein an atmosphere temperature of the patterning step is 120°C or less, wherein the patterning step comprises an etching process of etching a portion of the insulating layer (20) in the etch target area (22), and a stabilization process of reducing the atmosphere temperature of the patterning step, and in the patterning step, performing the etching process and the stabilization process constitutes one cycle, and two or more cycles are performed per layer of the insulating layer (20); and
a manufacturing step of manufacturing the packaging substrate (200) from the base substrate (100) on which the patterned insulating layer (21) is formed.

2. The method of claim 1, wherein in the patterning step, the etching mask (30) is disposed in contact with an upper surface of the insulating layer (20).

3. The method of claim 1, wherein the etching process is performed for 200 to 700 seconds per cycle.

4. The method of claim 1, wherein:
the etching process is performed in an atmosphere comprising a first etchant gas and a second etchant gas,
wherein the first etchant gas is a fluorine-based gas, and
wherein the second etchant gas is oxygen gas.

5. The method of claim 1, wherein plasma power of the etching process is 1.5 kW to 3 kW.

6. The method of claim 1, wherein a thickness of the etching mask is 5 µm to 40 µm.

7. The method of claim 1, further comprising a cleaning step of ultrasonically cleaning the base substrate (100) after the patterning step and before the manufacturing step, wherein a vibration frequency of the cleaning step is 30 kHz to 200 kHz.

8. The method of claim 1, wherein:
the patterned insulating layer (21) comprises a through hole (25) formed in a thickness direction of the insulating layer (20); and
a diameter of the through hole (25) is 3 µm to 50 µm.

9. The method of claim 1, wherein:
the packaging substrate (200) comprises the core layer (10) and the patterned insulating layer (21) disposed on the core layer (10),
wherein the packaging substrate (200) comprises an electrically conductive layer (40) formed at least partially in contact with an upper surface of the patterned insulating layer (21), and
a peel strength of the electrically conductive layer (40) to the upper surface of the patterned insulating layer (21) is 200 gf/cm or more.

## Patentansprüche

1. Verfahren zum Herstellen eines Verpackungssubstrats (200), wobei das Verfahren umfasst:
einen Erstellungsschritt zum Erstellen eines Basissubstrats (100), das eine Kernschicht (10) und eine auf der Kernschicht (10) gebildete Isolierschicht (20) umfasst, wobei die Isolierschicht (20) einen Ätzzielbereich (22) umfasst;
einen Strukturierungsschritt zum selektiven Plasmaätzen der Isolierschicht (20) mit einer Ätzmaske (30), um eine strukturierte Isolierschicht (21) zu bilden, wobei die Ätzmaske (30) eine organische Verbindung umfasst, wobei eine Atmosphärentemperatur des Strukturierungsschritts 120 °C oder weniger beträgt, wobei der Strukturierungsschritt einen Ätzprozess zum Ätzen eines Abschnitts der Isolierschicht (20) in dem Ätzzielbereich (22) und einen Stabilisierungsprozess zum Reduzieren der Atmosphärentemperatur des Strukturierungsschritts umfasst, und in dem Strukturierungsschritt das Durchführen des Ätzprozesses und des Stabilisierungsprozesses einen Zyklus bildet und zwei oder mehr Zyklen pro Schicht der Isolierschicht (20) durchgeführt werden; und
einen Herstellungsschritt zum Herstellen des Verpackungssubstrats (200) aus dem Basissubstrat (100), auf dem die strukturierte Isolierschicht (21) gebildet ist.

2. Verfahren nach Anspruch 1, wobei in dem Strukturierungsschritt die Ätzmaske (30) in Kontakt mit einer oberen Oberfläche der Isolierschicht (20) angeordnet ist.

3. Verfahren nach Anspruch 1, wobei der Ätzprozess für 200 bis 700 Sekunden pro Zyklus durchgeführt wird.

4. Verfahren nach Anspruch 1, wobei:
der Ätzprozess in einer Atmosphäre durchgeführt wird, die ein erstes Ätzgas und ein zweites Ätzgas umfasst,
wobei das erste Ätzgas ein Gas auf Fluorbasis ist, und
wobei das zweite Ätzgas Sauerstoffgas ist.

5. Verfahren nach Anspruch 1, wobei die Plasmaleistung des Ätzprozesses 1,5 kW bis 3 kW beträgt.

6. Verfahren nach Anspruch 1, wobei eine Dicke der Ätzmaske 5 µm bis 40 µm beträgt.

7. Verfahren nach Anspruch 1, ferner umfassend einen Reinigungsschritt zum Ultraschallreinigen des Basissubstrats (100) nach dem Strukturierungsschritt und vor dem Herstellungsschritt, wobei eine Schwingungsfrequenz des Reinigungsschritts 30 kHz bis 200 kHz beträgt.

8. Verfahren nach Anspruch 1, wobei:
die strukturierte Isolierschicht (21) ein Durchgangsloch (25) umfasst, das in einer Dickenrichtung der Isolierschicht (20) gebildet ist; und
ein Durchmesser des Durchgangslochs (25) 3 µm bis 50 µm beträgt.

9. Verfahren nach Anspruch 1, wobei:
das Verpackungssubstrat (200) die Kernschicht (10) und die auf der Kernschicht (10) angeordnete strukturierte Isolierschicht (21) umfasst,
wobei das Verpackungssubstrat (200) eine elektrisch leitfähige Schicht (40) umfasst, die zumindest teilweise in Kontakt mit einer oberen Oberfläche der strukturierten Isolierschicht (21) gebildet ist, und
eine Abziehfestigkeit der elektrisch leitfähigen Schicht (40) von der oberen Oberfläche der strukturierten Isolierschicht (21) 200 gf/cm oder mehr beträgt.

## Revendications

1. Procédé de fabrication d'un substrat d'encapsulation (200), ledit procédé comprenant :
une étape de préparation consistant à préparer un substrat de base (100) comprenant une couche centrale (10) et une couche isolante (20) formée sur la couche centrale (10), la couche isolante (20) comprenant une zone de gravure cible (22) ;
une étape de formation de motif consistant à graver sélectivement au plasma la couche isolante (20) avec un masque de gravure (30) pour former une couche isolante à motif (21), où ledit masque de gravure (30) comprend un composé organique, où la température atmosphérique de l'étape de formation de motif est inférieure ou égale à 120 °C, où l'étape de formation de motif comprend un processus de gravure consistant à graver une partie de la couche isolante (20) dans la zone de gravure cible (22), et un processus de stabilisation consistant à réduire la température atmosphérique de l'étape de formation de motif, et où, lors de l'étape de formation de motif, l'exécution du processus de gravure et du processus de stabilisation constitue un cycle, et deux cycles ou plus sont exécutés par couche de la couche isolante (20) ; et
une étape de fabrication consistant à fabriquer le substrat d'encapsulation (200) à partir du substrat de base (100) sur lequel la couche isolante à motif (21) est formée.

2. Procédé selon la revendication 1, où, lors de l'étape de formation de motif, le masque de gravure (30) est disposé en contact avec une surface supérieure de la couche isolante (20).

3. Procédé selon la revendication 1, où le processus de gravure est exécuté pendant 200 à 700 secondes par cycle.

4. Procédé selon la revendication 1, où :
le procédé de gravure est exécuté dans une atmosphère comprenant un premier gaz de gravure et un deuxième gaz de gravure,
où le premier gaz de gravure est un gaz à base de fluor, et
où le deuxième gaz de gravure est de l'oxygène.

5. Procédé selon la revendication 1, où la puissance du plasma du processus de gravure est comprise entre 1,5 kW et 3 kW.

6. Procédé selon la revendication 1, où l'épaisseur du masque de gravure est comprise entre 5 µm et 40 µm.

7. Procédé selon la revendication 1, comprenant en outre une étape de nettoyage consistant à nettoyer par ultrasons le substrat de base (100) après l'étape de formation de motif et avant l'étape de fabrication, la fréquence de vibration de l'étape de nettoyage étant comprise entre 30 kHz et 200 kHz.

8. Procédé selon la revendication 1, où :
la couche isolante à motif (21) comprend un trou traversant (25) formé dans le sens de l'épaisseur de la couche isolante (20) ; et
le diamètre du trou traversant (25) est compris entre 3 µm et 50 µm.

9. Procédé selon la revendication 1, où :
le substrat d'encapsulation (200) comprend la couche centrale (10), et la couche isolante à motif (21) disposée sur la couche centrale (10),
où le substrat d'encapsulation (200) comprend une couche électriquement conductrice (40) formée au moins partiellement en contact avec une surface supérieure de la couche isolante à motif (21), et
la résistance au pelage de la couche électriquement conductrice (40) sur la surface supérieure de la couche isolante à motif (21) est de 200 gf/cm ou plus.
